# EUROPÄISCHE PATENTSCHRIFT

(11) **EP 0 912 774 B1**
(45) Veröffentlichungstag und Bekanntmachung des Hinweises auf die Patenterteilung: **21.08.2002**
(21) Anmeldenummer: 97930386.4
(22) Anmeldetag: 24.06.1997
(51) Int. Cl.: C23C 14/02, C23C 14/06, C23C 14/34

(54) **VERFAHREN ZUR HERSTELLUNG EINES STOFFVERBUNDS**
METHOD OF MANUFACTURING A COMPOSITE MATERIAL
PROCEDE DE PRODUCTION D'UN MATERIAU COMPOSITE

(30) Priorität: 25.06.1996 DE 19625329
(43) Veröffentlichungstag der Anmeldung: 06.05.1999
(73) Patentinhaber: Forschungszentrum Karlsruhe GmbH, 76133 Karlsruhe (DE)
(72) Erfinder: HOLLECK, Helmut, D-76139 Karlsruhe (DE); STÜBER, Michael, D-76228 Karlsruhe (DE)
(74) Vertreter: Rückert, Friedrich, Dr.
(86) Internationale Anmeldenummer: EP9703292
(87) Internationale Veröffentlichungsnummer: WO97049840

(56) Entgegenhaltungen:
- EP-A- 0 267 679
- EP-A- 0 294 572
- DE-C- 19 502 568
- DATABASE WPI Section Ch, Week 9215 Derwent Publications Ltd., London, GB; Class L03, AN 92-120351 XP002042712 & JP 04 064 920 A (KUBOTA CORP) , 28.Februar 1992
- HOLMBERG K ET AL: "TRIBOLOGICAL CHARACTERISTICS OF HYDROGENATED AND HYDROGEN-FREE DIAMOND-LIKE CARBON COATINGS" DIAMOND FILMS AND TECHNOLOGY, Bd. 4, Nr. 2, Seiten 113-129, XP000570628

## Beschreibung

Die Erfindung betrifft ein Verfahren zur Herstellung eines Stoffverbund gemäß dem Oberbegriff des ersten Patentanspruchs und ein Verfahren zu dessen Herstellung gemäß dem fünften Patentanspruch.

Ein solcher Stoffverbund und verschiedene Verfahren zu seiner Herstellung werden in der Veröffentlichung von S. J. Bull: "Tribology of carbon coatings: DLC, diamond and beyond". Diamond and Related Materials 4 (1995) 827-836 beschrieben. Die Veröffentlichung betrifft auf Substrate aufgebrachte amorphe Kohlenstoffschichten, die sowohl sp²- als auch sp³-Bindungen enthalten. Solche Kohlenstoffschichten werden als "diamondlike" carbon (DLC-) Schichten bezeichnet. Die Härte solcher Schichten hängt von verschiedenen Parametern, insbesondere vom Anteil der sp³ hybridisierten Bindungen bzw. der Bias-Spannung während der Herstellung durch Sputterverfahren ab. Die Haftung der Schichten auf dem Substrat sieht der Autor als problematisch an. Da diamantähnliche Schichten chemisch inert sind, gehen sie keine Bindung zum Substrat ein. Deshalb wird oft auf das Substrat ein Carbid bildendes Element als Zwischenlage aufgebracht, das für diamantähnliche Schichten die beste Haftung gewährleistet. Für eine solche Zwischenlage eignet sich Silicium und Siliciumcarbid. Auf komplizierter aufgebaute Zwischenlagen wird hingewiesen. Ein weiteres Problem ist, daß die höchste Härte mit solchen diamantähnlichen Schichten erzielt wird, die hohe innere Spannungen aufweisen.

Auch in den Proceedings der 2nd International Conference on the Applications of Diamond Films and Related Materials, Editors M. Yoshikawa et al, Seite 221 bis 228 (Richard L. C. Wu und Kazuhisa Miyoshi: "Application of Diamond and Diamond-Like Carbon Films as Lubricating Coatings"), MYU, Tokyo 1993 wird über diamantähnliche Schichten berichtet, die durch direkte Ionenstrahl-Abscheidung von einer Kaufman-Ionenquelle auf ein Substrat ([100] Si) aufgebracht wurden. Die Autoren geben an, daß der Anteil des sp³ hybridisierten Kohlenstoffs ca. 50 mal so groß war wie der sp² hybridisierte Anteil. Die Schichten erwiesen sich als sehr hart und amorph.

Weiterhin findet sich in diesen Proceedings eine Veröffentlichung von Erich Bergmann: "Industrial Applications of Metal Containing Diamond Like Carbon Films" (Seiten 833-844). Der Autor vergleicht reine diamantartige Kohlenstoffschichten mit metallhaltigen diamantartigen Kohlenstoffschichten und kommt zum Ergebnis, daß mit den metallhaltigen Schichten unter anderem das Problem der Haftung auf dem Substrat vermieden werden kann.

Der Erfindung liegt die Aufgabe zugrunde, einen Stoffverbund der eingangs genannten Art zu erzeugen, bei dem die Haftung zwischen Substrat und Kohlenstoffschicht verbessert und innere Spannungen in der Kohlenstoffschicht trotz hoher Härte der Schichtoberfläche minimiert werden können. Außerdem soll ein neues Verfahren vorgeschlagen werden, mit dessen Hilfe sich der Stoffverbund herstellen läßt.

Erfindungsgemäß wird die Aufgabe durch das im Anspruch 1 beschriebene Verfahren gelöst. In den weiteren Ansprüchen werden bevorzugte Ausgestaltungen des Verfahrens angegeben.

Erfindungsgemäß ist eine Gradientenschicht auf einem Substrat aufgebaut. Für den Werkstoff des Substrats bestehen praktisch keine Einschränkungen; das Substrat kann aus Metall, Keramik oder einem thermisch ausreichend belastbaren Kunststoff bestehen.

In der Regel haftet die Gradientenschicht bei geringen Schichtdicken gut auf dem Substrat. Falls bei dickeren Schichten (etwa über 1 µm) die Haftung nicht ausreichend sein sollte, kann eine Zwischenlage vorzugsweise aus einem Carbid, Nitrid oder Borid eines Übergangsmetalls vorgesehen werden. Gut geeignet ist TiC als Zwischenlage. Die Dicke der Zwischenlage soll ca. 5 bis 300 nm, bevorzugt 5 bis 50 nm betragen; sie kann nach den bekannten Methoden, z. B. durch Magnetronsputtern, aufgebracht werden.

Die Gradientenschicht, die auf dem Substrat oder gegebenenfalls auf der Zwischenlage aufgebaut ist, besteht aus - abgesehen von unvermeidbaren Verunreinigungen - reinem Kohlenstoff. Sie ist vorzugsweise zwischen 0,5 µm und 5 µm, besser zwischen 1 und 3 µm dick. Die Grenzfläche zum Substrat oder zur Zwischenschicht soll einen überwiegenden Anteil an sp² hybridisierten Bindungen haben; sie ist amorph, arm an inneren Spannungen und mit 1600 bis 2000 HV relativ weich. Dieser Teil der Schicht vermittelt die Haftung zum Substrat oder zur Zwischenschicht. In Richtung auf die freie Oberfläche der Schicht steigt der Anteil an sp³ hybridisierten Bindungen an, so daß schließlich der sp²-Hybridisierungsanteil zurücktritt und die sp³-Bindungen überwiegen. Die freie Oberfläche der Schicht besteht daher aus diamantartigem und damit entsprechend hartem Kohlenstoff.

Die Herstellung solcher Schichten gelingt mit Hilfe von PVD-Verfahren. Damit sich die gewünschte Gradientenschicht ergibt, muß während der Herstellung der Schicht der Impulseintrag in die Schicht gesteigert werden. Wird der Impulseintrag kontinuierlich gesteigert, ergibt sich entsprechend eine Gradientenschicht, deren innere Spannung und Härte von der Grenzschicht bis zur Oberfläche kontinuierlich ansteigen. Der Impulseintrag kann aber auch diskontinuierlich gesteigert werden. In diesem Fall ergibt sich eine Gradientenschicht, deren Eigenschaften sich zwischen Grenzschicht und Oberfläche stufenförmig ändern.

Die Erfindung wird im folgenden anhand eines Ausführungsbeispiels und sieben Figuren näher erläutert.

Es zeigen
Fig. 1 eine schematische Darstellung einer Ausführungsform des erfindungsgemäßen Stoffverbunds;
Fig. 2 den Einfluß des Gradienten der Bias-Spannung auf die Härte der Kohlenstoffschicht des Stoffverbunds;
Fig. 3 einen Vergleich der thermischen Leitfähigkeit verschiedener Kohlenstoffschichten;
Fig. 4 die Druckeigenspannungen einer amorphen Kohlenstoffschicht und der Kohlenstoffschicht des erfindungsgemäßen Stoffverbunds;
Fig. 5 die kritischen Lasten des Versagens für verschiedene Kohlenstoffschichten;
Fig. 6 die an einer amorphen Kohlenstoffschicht und an der Kohlenstoffschicht des erfindungsgemäßen Stoffverbunds gemessenen Reibungszahlen;
Fig. 7 die Eindringtiefe eines Prüfkörpers (Nanoindenter) in eine amorphe Kohlenstoffschicht und in den erfindungsgemäßen Stoffverbund.

### Ausführungsbeispiel:

Herstellung einer Ausführungsform des erfindungsgemäßen Stoffverbunds

Durch Magnetronsputtern von einem Graphittarget bei 150 W Leistung und 0,6 bis 1,0 Pa Argonpartialdruck (alternativ: 90 Vol.-% Ar, 10 Vol.-% H₂) wurden auf verschiedene Substrate bei einer Abscheidetemperatur von 100 bis 200 °C Kohlenstoffschichten mit einer Gesamtschichtdicke von 1 bis 5 µm abgeschieden. Die Substrate bestanden aus Silicium, Hartmetall, Aluminium, Aluminiumoxid und Siliciumcarbid; sie wurden vor der Beschichtung mit 500 W HF 10 Minuten lang geätzt. Die Zwischenlage wurde hergestellt, indem in der Prozeßkammer der Magnetronsputteranlage auf den Substraten eine 5 bis 100 nm dicke TiC-Schicht durch Sputtern von einem TiC-Target abgeschieden wurde. Die anschließende Kohlenstoffabscheidung wurde in derselben Prozeßkammer durch Sputtern des Graphit-Targets vorgenommen. Während der Kohlenstoffabscheidung wurde die Biasspannung kontinuierlich von 0 V auf 300 V erhöht. Bei einigen Substraten wurde die Kohlenstoffschicht in drei Stufen aufgebaut: 30 min. bei 0 V Bias-Spannung, 30 bis 40 min. bei 150 V Biasspannung und 30 min. bei 300 V Biasspannung.

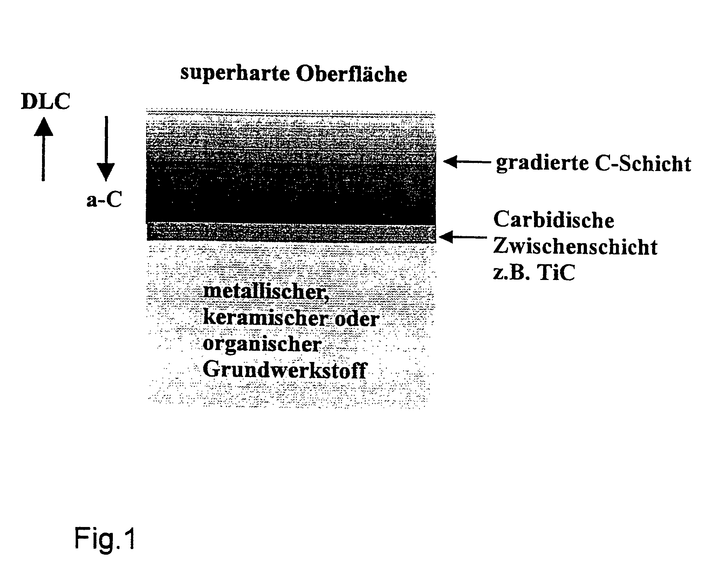

In Fig. 1 ist eine Ausführungsform des erfindungsgemäßen Schichtverbunds Auf einem Substrat aus Hartmetall ist eine ca. 200 nm dicke Schicht aus Titancarbid aufgetragen. Auf der Titancarbidschicht liegt eine gradierte Kohlenstoffschicht, die durch kontinuierliche Erhöhung der Bias-Spannung wie im Ausführungsbeispiel beschrieben hergestellt wurde. Die Schichtdicke beträgt 2 µm. Die in den folgenden Figuren dargestellten Ergebnisse wurden, soweit nicht anders angegeben, mit diesem Stoffverbund erhalten.

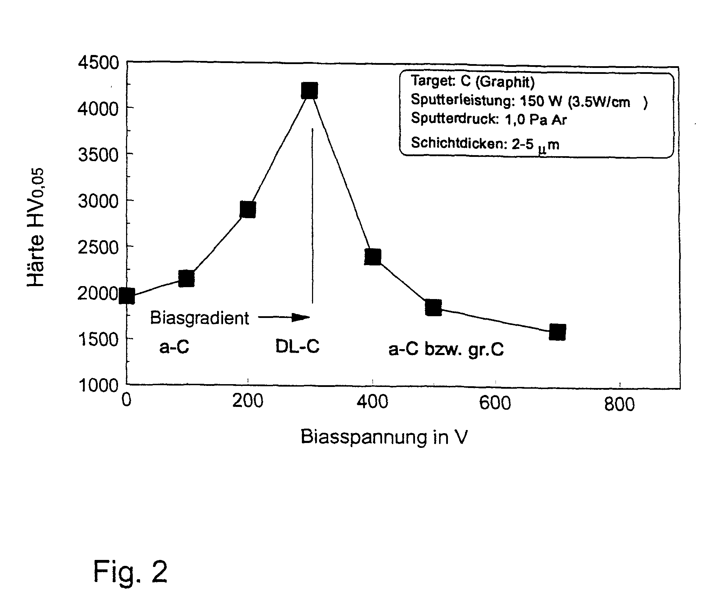

Fig. 2 zeigt die Abhängigkeit der Härte HV_{0,05} vom Gradienten der Bias-Spannung. Der Gradient der Bias-Spannung gibt an, bis zu welcher Höhe die Bias-Spannung während der Herstellung der Schicht von der Spannung 0 V aus erhöht wurde. Die untersuchten homogenen, gradierten Kohlenstoffschichten waren jeweils 2 bis 5 µm dick. Das Target bestand aus Graphit; die Sputterleistung betrug 150 W (3,5 W/cm) und der Sputterdruck 1,0 Pa Ar. Bei Bias-Spannungen unter 200 V bilden sich amorphe Kohlenstoffschichten, deren sp³-Anteil mit der Bias-Spannung zunimmt. Die höchste Härte ergibt sich bei einer Bias-Spannung von ca. 300 V. Bei höheren Bias-Spannungen sinkt die Härte wieder ab, wobei sich wiederum amorphe, graphitähnliche Schichten ergeben.

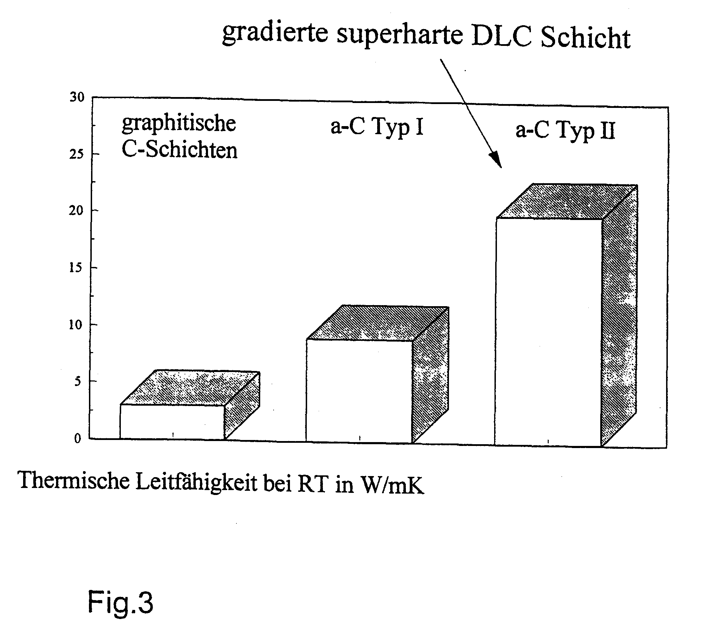

In Fig. 3 sind die thermischen Leitfähigkeiten verschiedener Kohlenstoffschichten bei Raumtemperatur in [W/mK] dargestellt. Die linke Säule zeigt als Vergleichsmaßstab die Wärmeleitfähigkeit homogener graphitischer Kohlenstoffschichten. Die mittlere Säule gibt die Wärmeleitfähigkeit solcher amorpher Schichten an, die den Grenzflächenbereichen des erfindungsgemäßen Stoffverbunds entsprechen. Die rechte Säule repräsentiert die Gradientenschicht des erfindungsgemäßen Stoffverbunds. Die Wärmeleitfähigkeit der Gradientenschicht ist gegenüber graphitischen Kohlenstoffschichten um mehr als Faktor 4 höher.

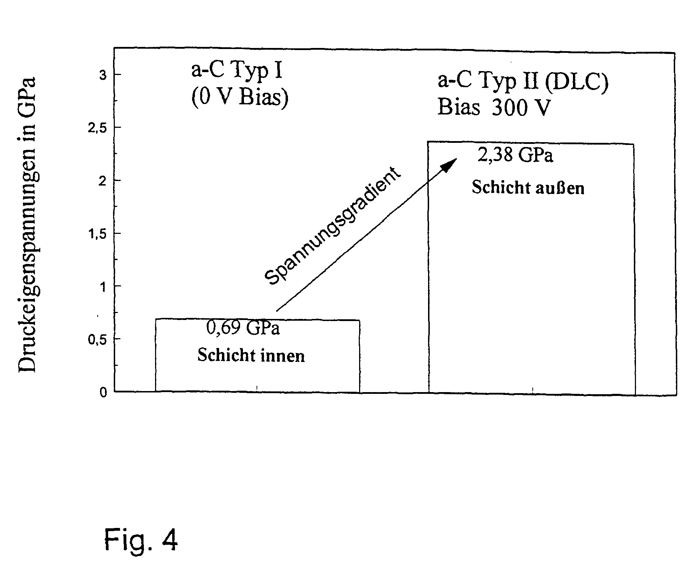

In Fig. 4 sind die Druckeigenspannungen in [GPa] in amorphen Kohlenstoffschichten angegeben. Die linke Säule bezeichnet die Druckeigenspannung des amorphem Kohlenstoffs mit hohem sp²-Hybridisierungsanteil, der erfindungsgemäß in der Kohlenstoffschicht des Stoffverbunds an der Grenzfläche zum Substrat oder zur Zwischenlage bei einer Bias-Spannung von 0 V erzeugt wird. Die Druckeigenspannung beträgt 0,69 GPa. Die rechte Säule gibt die Druckeigenspannung (238 GPa) einer gesamten Kohlenstoff-Gradientenschicht wieder, bei der die Bias-Spannung bis auf 300 V erhöht wurde. Noch höher wäre die Druckeigenspannung der an der Oberfläche der Gradientenschicht; die hohe Druckeigenspannung der Oberfläche wird jedoch durch den weicheren Grenzflächenbereich teilweise kompensiert.

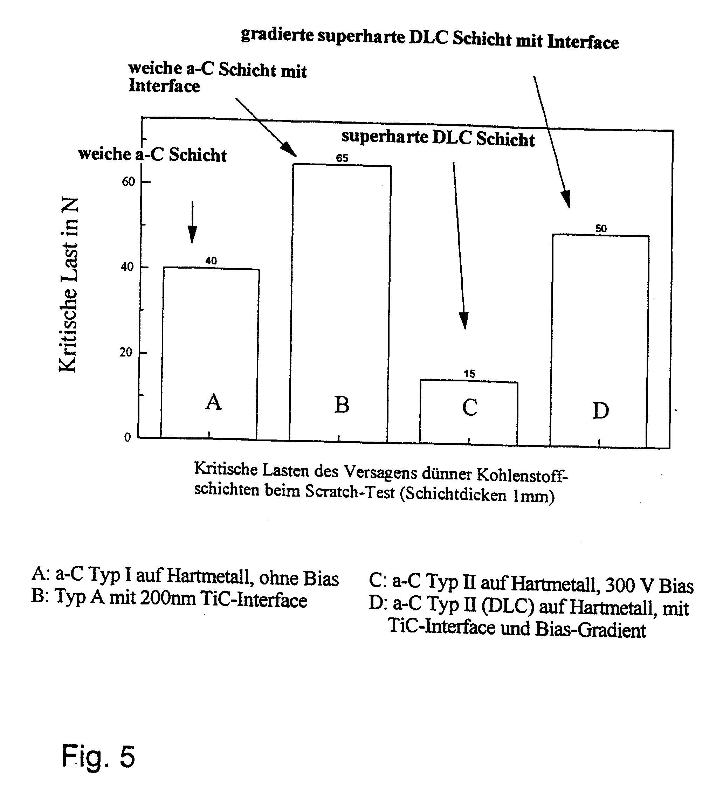

In Fig. 5 sind die kritischen Lasten in [N] des Versagens dünner Kohlenstoffschichten beim Scratch-Test aufgetragen. Die Schichtdicke betrug 1 µm. Die Säule A stellt eine unmittelbar, somit ohne Zwischenlage auf einem Hartmetallsubstrat aufgebrachte Kohlenstoffschicht dar, die bei einer Bias-Spannung von 0 V der amorphen Kohlenstoffschicht an der Grenzfläche des erfindungsgemäßen Stoffverbunds entspricht; die kritische Last beträgt 40 N. Die Säule B repräsentiert einen Stoffverbund, der A entspricht, wobei jedoch eine 200 nm dicke Zwischenlage aus TiC vorhanden ist; die kritische Last beträgt 65 N. Mit der Säule C ist die kritische Last eines Stoffverbunds aus Hartmetall und einer diamantartigen Schicht mit hohem sp³-Hybridisierungsanteil angegeben (15 N), der bei einem Bias-Spannungsgradienten von 300 V hergestellt wurde, keine Zwischenschicht aufweist und in ihrer Morphologie der Oberfläche der erfindungsgemäß vorgesehenen Gradientenschicht entspricht. Schließlich zeigt die Säule D die kritische Last (50 N) einer Ausführungsform des erfindungsgemäßen Stoffverbunds mit einem Hartmetallsubstrat, einer 200 nm dicken TiC-Zwischenlage und einem zwischen 0 und 300 V kontinuierlich veränderten Bias-Gradienten. Man sieht, daß die kritische Last für den erfindungsgemäßen Stoffverbund hoch ist, obwohl die superharte Oberfläche der Kohlenstoffgradientenschicht stark druckspannungsbehaftet ist.

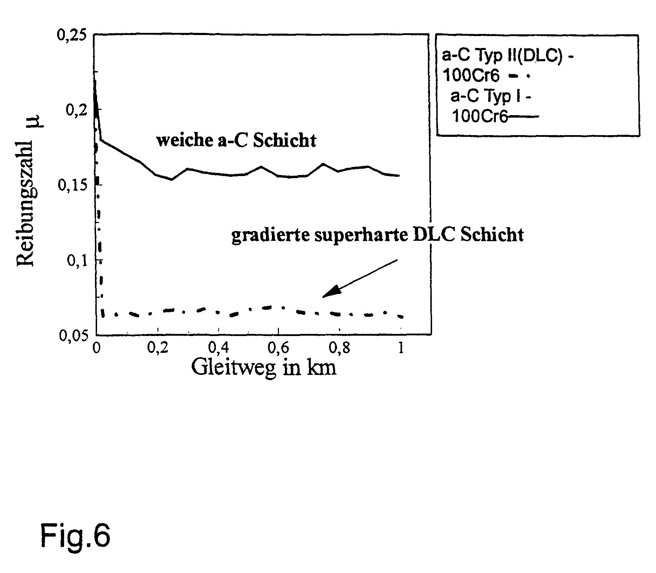

In Fig. 6 ist die Reibungszahl µ gegen den Gleitweg in [km] aufgetragen. Die durchgezogene Linie entspricht der durch Säule A in Fig. 5 repräsentierten Schicht. Mit der gestrichelten Linie ist die Reibung für den erfindungsgemäßen Stoffverbund dargestellt. Die Reibung des Stoffverbunds ist erheblich geringer. Die Messungen wurden bei Gleitverschleiß (10 N, relative Luftfeuchte 35 %, v = 0,03 m/s) gegen 100Cr6 durchgeführt.

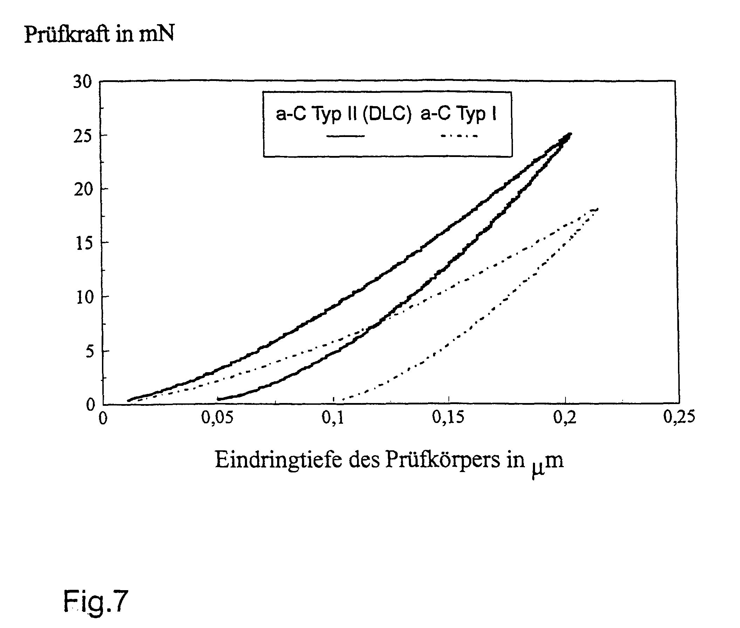

In Fig. 7 ist die Prüfkraft in mN gegen die Eindringtiefe des Prüfkörpers in µm dargestellt. Die durchgezogene Kurve zeigt die Ergebnisse für den erfindungsgemäßen Stoffverbund, während die gestrichete Kurve die zu Säule A in Fig. 5 beschriebene Kohlenstoffschicht repräsentiert. Die Eindringtiefen des erfindungsgemäßen Stoffverbunds sind deutlich kleiner und zeigen einen relativ hohen elastischen Anteil.

## Patentansprüche

1. Verfahren zur Herstellung eines Stoffverbunds
- aus einem Substrat und
- einer im wesentlichen aus reinem, sp² und sp³ hybridisiertem Kohlenstoff bestehenden Schicht, die eine erste, dem Substrat gegenüberliegende und eine zweite, freie Fläche aufweist,
- wobei die Schicht eine Gradientenschicht ist, bei der der Anteil des sp³ hybridisierten Kohlenstoffs in Richtung auf die zweite, freie Fläche ansteigt, bei dem
a) auf dem Substrat die Schicht aus Kohlenstoff mit einem PVD-Verfahren in der Weise abgeschieden wird, daß während der Herstellung der Schicht in einer Prozeßkammer einer Magnetronsputteranlage ein Argon-Partialdruck von 0,6 bis 1,0 Pa eingestellt wird und
b) daß während der Abscheidung des Kohlenstoffs die Bias-Spannung kontinuierlich oder diskontinuierlich von 0 Volt auf 300 Volt erhöht wird, wodurch ein Impulseintrag in die Schicht mit steigender Schichtdicke in gleichem Maß kontinuierlich oder diskontinuierlich gesteigert wird.

2. Verfahren nach Anspruch 1, bei dem
vor der Abscheidung der Schicht aus Kohlenstoff in der Prozeßkammer auf dem Substrat durch Sputtern von einem aus einem Carbid, Nitrid oder Borid eines Übergangsmetalls bestehenden Target auf dem Substrat eine Zwischenlage aus dem Carbid des Übergangsmetalls hergestellt wird.

3. Verfahren nach Anspruch 2, bei dem
die Zwischenlage in einer Dicke von 5 bis 300 nm erzeugt wird.

4. Verfahren nach Anspruch 1, 2 oder 3, bei dem
die Schicht aus Kohlenstoff in einer Dicke von 0,5 bis 5 µm erzeugt wird.

## Claims

1. Method of producing a composite substance
- from a substrate and
- from a layer, which is substantially formed from pure, sp₂-and sp₃-hybridised carbon and has a first face situated opposite the substrate and a second exposed face,
- the layer being a gradient layer, wherein the proportion of the sp₃-hybridised carbon increases towards the second exposed face,
wherein
a) the layer of carbon is deposited on the substrate by a PVD method in such a manner that, during the production of the layer in a processing chamber of a magnetron sputtering system, an argon partial pressure is set from 0.6 to 1.0 Pa, and
b) in such a manner that, during the deposition of the carbon, the bias voltage is continuously or discontinuously increased from 0 volt to 300 volts, whereby a pulse input into the layer of increasing layer thickness is continuously or discontinuously increased to the same extent.

2. Method according to claim 1, wherein, prior to the deposition of the layer of carbon in the processing chamber on the substrate by sputtering a target on the substrate, which target is formed from a carbide, nitride or boride of a transition metal, an intermediate layer is produced from the carbide of the transition metal.

3. Method according to claim 2, wherein the intermediate layer is produced in a thickness of 5 to 300 nm.

4. Method according to claim 1, 2 or 3, wherein the layer is produced from carbon in a thickness of 0.5 to 5 µm.

## Revendications

1. Procédé de fabrication d'un matériau composite
- à partir d'un substrat et
- d'une couche constituée essentiellement de carbone pur hybridé sp² et sp³, qui présente une première surface, faisant face au substrat, et une seconde surface, libre,
- la couche étant une couche à gradient dans laquelle la proportion du carbone à hybridation sp³ augmente en direction de la seconde surface, celle qui est libre, selon lequel
a) sur le substrat la couche de carbone est déposée par un procédé PVD de manière qu'au cours de la production de la couche dans la chambre de réaction d'une installation de projection d'un magnétron on établisse une pression partielle d'argon de 0,6 à 1,0 Pa et
b) au cours du dépôt du carbone, la tension de polarisation s'accroît de façon continue ou discontinue de 0 volt à 300 volts, ce qui augmente dans la même mesure de façon continue ou discontinue la réception des impulsions dans la couche lorsque son épaisseur augmente.

2. Procédé selon la revendication 1,
dans lequel
avant le dépôt de la couche de carbone dans la chambre de réaction sur le substrat, on fabrique par projection à partir d'une cible constituée d'un carbure, nitrure ou borure d'un métal de transition, on fabrique une couche intermédiaire en carbure du métal de transition.

3. Procédé selon la revendication 2,
dans lequel
la couche intermédiaire produite a une épaisseur de 5 à 300 nm.

4. Procédé selon la revendication 1, 2 ou 3,
dans lequel
la couche de carbone produite a une épaisseur de 0,5 à 5 µm.
